**Europäisches Patentamt**

**European Patent Office**

**Office européen des brevets**

(19)

(11) Veröffentlichungsnummer : **0 357 977 B1**

(12)

# EUROPÄISCHE PATENTSCHRIFT

(45) Veröffentlichungstag der Patentschrift :
**01.07.92 Patentblatt 92/27**

(51) Int. Cl.$^5$ : **B23K 3/04, // H05K3/34**

(21) Anmeldenummer : **89114586.4**

(22) Anmeldetag : **07.08.89**

(54) **Lötvorrichtung mit mindestens einer durch elekrische Widerstandswärme erhitzbaren Bügelelektrode.**

(30) Priorität : **07.09.88 DE 3830407**

(43) Veröffentlichungstag der Anmeldung :
**14.03.90 Patentblatt 90/11**

(45) Bekanntmachung des Hinweises auf die
Patenterteilung :
**01.07.92 Patentblatt 92/27**

(84) Benannte Vertragsstaaten :
**CH DE FR GB IT LI NL**

(56) Entgegenhaltungen :
**DE-A- 3 149 236**
**FR-A- 1 366 277**
**FR-A- 2 273 624**

(73) Patentinhaber : **SIEMENS**
**AKTIENGESELLSCHAFT**
**Wittelsbacherplatz 2**
**W-8000 München 2 (DE)**

(72) Erfinder : **Hacke, Hans-Jürgen, Dipl.-Ing.**
**Malojaweg 7**
**W-8000 München 71 (DE)**
Erfinder : **Heiss, Lorenz, Ing.grad.**
**Gottlob-Weiler-Strasse 9**
**W-8206 Bruckmühl (DE)**
Erfinder : **Korodi, Helmut, Dipl.-Ing.(FH)**
**Ina-Seidel-Weg 4**
**W-8206 Bruckmühl (DE)**
Erfinder : **Wirbser, Oscar, Dipl.-Ing.(FH)**
**Kreuzlinger Strasse 73**
**W-8034 Germering (DE)**

## Beschreibung

Die Erfindung betrifft eine Lötvorrichtung mit mindestens einer durch elektrische Widerstandswärme erhitzbaren Bügelelektrode, insbesondere für das Auflöten hochpoliger elektronischer Bauelemente auf Leiterplatten.

Eine derartige Lötvorrichtung ist beispielsweise aus der DE-A-31 49 236 bekannt. Der Elektrodenhalter dieser bekannten Lötvorrichtung umfaßt elektrisch voneinander isolierte, kleine Säulen aus leitfähigem Material, zwischen deren Enden in auswechselbarer Weise mindestens zwei Bügelelektroden befestigt sind. Die U-förmigen Bügelelektroden, die durch elektrische Widerstandswärme erhitzt werden können, sind aus einer ebenen Platte aus einem Widerstandsmaterial wie Tantal oder Molybdän hergestellt und in der Weise angebracht, daß sie mit der Unterseite ihres Löteteges in Kontakt mit den zu verlötenden Elementen kommen. Bei einer Anzahl von zwei oder vier Bügelelektroden werden für die Elektrodenhalter insgesamt vier kleine Säulen benötigt, die auf einer jeweiligen Diagonalen der Lötvorrichtung angeordnet sind und durch mehrere kreuzförmige Verstrebungen mechanisch miteinander verbunden sind. Zur Stromversorgung von vier Bügelelektroden werden zwei auf einer Diagonale liegende kleine Säulen mit dem einen Pol einer Stromquelle verbunden, während die beiden anderen kleinen Säulen mit dem anderen Pol der Stromquelle verbunden werden.

Aus der FR-A-23 88 626 ist eine andere Lötvorrichtung bekannt, bei welcher der Elektrodenhalter zwei elektrisch voneinander isolierte kleine Säulen aus leitfähigem Material umfaßt, zwischen deren Enden eine einzige Bügelelektrode in auswechselbarer Weise befestigt ist. Diese Bügelelektrode besitzt jedoch insgesamt vier Lötstege, welche die Form eines einstückigen, rechteckförmigen Rahmens aufweisen, wobei zwei einander gegenüberliegende Lötstege über nach oben ragende Fortsätze an den zugeordneten kleinen Säulen auswechselbar befestigt sind.

Die vorstehend geschilderten bekannten Lötvorrichtungen werden insbesondere für das Auflöten hochpoliger elektronischer Bauelemente wie Mikropacks, Flatpacks und dgl. auf Leiterplatten eingesetzt, wobei die Widerstandserwärmung der Bügelelektroden durch Stromimpulse vorgenommen wird. Bei speziellen Anwendungsfällen, wie beim Auflöten mehrpoliger Bauelemente auf mehrlagige Leiterplatten, muß verhindert werden, daß der den Bügelelektroden zugeführte Strom über niederohmige Leiterbahnen auf den Innenlagen der mehrlagigen Leiterplatte abfließt und dadurch eine für den beabsichtigten Lötvorgang ausreichende Widerstandserwärmung der Bügelelektroden nicht mehr gewährleistet ist. Versuche dieses Abfließen des den Bügelelektroden zugeführten Stroms durch eine elektrisch isolierende Beschichtung der Bügelelektroden zu verhindern, sind bislang fehlgeschlagen. So führte das Aufbringen von Aluminiumoxid oder anderer Oxide oder von PTFE als Isolation mit Schichtdicken von mehr als 1 µm bereits nach wenigen Erwärmungen dazu, daß die Schichten ganz oder teilweise abplatzten. Dagegen haben Schichten mit Schichtdicken von weniger als 1 µm eine ausreichende Haftung, jedoch haben sie eine sehr geringe Standzeit, da diese dünnen Schichten beim Planschleifen und Reinigen im Fertigungseinsatz immer mehr abgetragen werden, so daß eine sichere Isolation nicht mehr gewährleistet ist.

Aus der FR-A-13 66 277 ist eine Lötvorrichtung zum Auflöten hochpoliger elektronischer Bauelemente auf Leiterplatten bekannt, bei welcher Platten aus Wolfram, Aluminiumoxid oder Berylliumoxid zwischen die sinusförmigen Bögen drahtförmiger Elektroden eingefügt werden. Ein Abfließen des den Elektroden zugeführten Stromes über niederohmige Leiterbahnen ist bei dieser Elektrodenform nicht zu befürchten. Andererseits verhindert der schlechte Wärmeübergang zwischen den sinusförmigen Bögen und den Platten eine rasche und gleichmäßige Erwärmung der Platten.

Aus der FR-A-22 73 624 ist eine Lötvorrichtung zum Auflöten hochpoliger elektronischer Bauelemente auf Leiterplatten bekannt, bei welcher stabförmige Lötelemente aus Kupfer durch eingesetzte Heizpatronen elektrisch beheizt werden. In die Unterseiten der mit einer lotabweisenden Beschichtung versehenen Lötelemente sind Nuten eingebracht, in welchen streifenförmige Einsätze aus unbeschichtetem Kupfer auswechselbar angeordnet sind.

Der Erfindung liegt die Aufgabe zugrunde, eine Lötvorrichtung mit mindestens einer durch elektrische Widerstandswärme erhitzbaren Bügelelektrode so auszugestalten, daß beim Auflöten hochpoliger elektronischer Bauelemente auf Leiterplatten ein Abfließen des Bügelelektrodenstroms über niederohmige Leiterbahnen mit Sicherheit ausgeschlossen werden kann.

Diese Aufgabe wird bei einer Lötvorrichtung der eingangs genannten Art erfindungsgemäß dadurch gelöst, daß in die Unterseite des Löteteges der Bügelelektrode eine Nut eingebracht ist und daß in der Nut ein streifenförmiger Einsatz aus einem elektrisch nichtleitenden, gut wärmeleitenden Werkstoff befestigt ist. Dadurch ist gewährleistet, daß die Wärme von der widerstandserwärmten Bügelelektrode über den streifenförmigen Einsatz auf die Anschlüsse des hochpoligen elektronischen Bauelementes und das darunter befindliche Lot übertragen wird. Nach dem Aufschmelzen des Lotes werden die Anschlüsse durch die Bügelelektrode mit dem streifenförmigen Einsatz so lange niedergehalten, bis das Lot erstarrt ist. Durch die mechanische Verankerung

2

der streifenförmigen Einsätze in einer Nut der Bügelelektrode können sehr hohe Standzeiten realisiert werden.

Gemäß einer bevorzugten Ausgestaltung der Erfindung besteht der streifenförmige Einsatz aus einem keramischen Werkstoff. Derartige keramische Werkstoffe, die eine sehr gute elektrische Isolation bilden, sind für die Bedingungen im Fertigungseinsatz besonders gut geeignet. Dabei haben sich als keramische Werkstoffe insbesondere Aluminiumoxid, Berylliumoxid und Aluminiumnitrid bewährt.

Eine sehr gute mechanische Verankerung des streifenförmigen Einsatzes in der Nut der Bügelelektrode ist dann gewährleistet, wenn der streifenförmige Einsatz in die Nut eingesintert ist. Ähnlich gute Ergebnisse können jedoch auch dann erzielt werden, wenn der streifenförmige Einsatz in die Nut eingeklebt ist. In diesem Fall wird der streifenförmige Einsatz insbesondere mittels eines Wärmeleitklebers in die Nut eingeklebt, so daß ein guter Wärmeübergang von der Bügelelektrode zu dem streifenförmigen Einsatz gewährleistet ist.

Ein Ausführungsbeispiel der Erfindung ist in der Zeichnung dargestellt und wird im folgenden näher beschrieben.

Es zeigen:

Figur 1 eine Lötvorrichtung mit insgesamt vier Bügelelektroden und

Figur 2 einen Querschnitt, welcher die Verankerung eines streifenförmigen Einsatzes in der Unterseite einer Bügelelektrode aufzeigt.

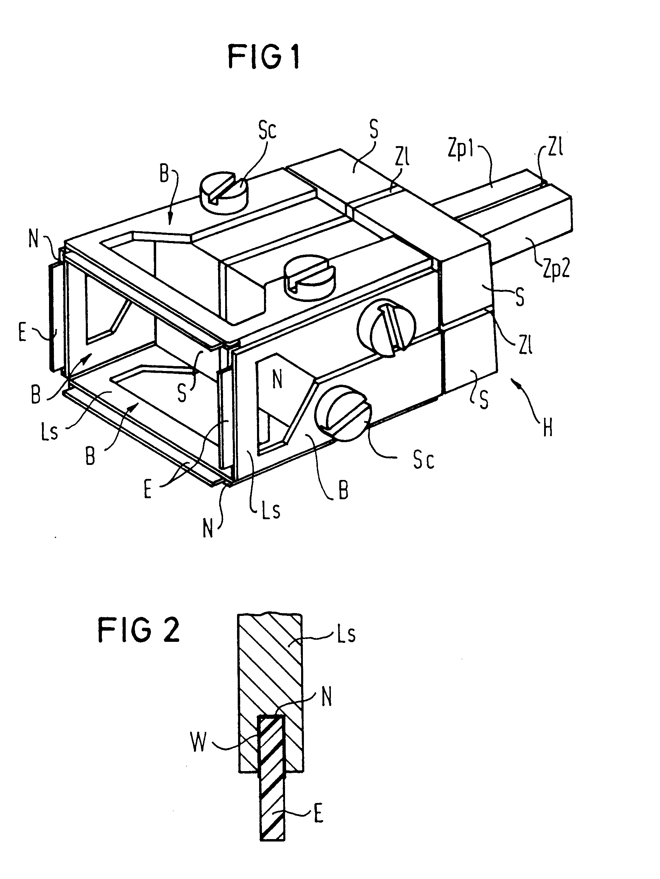

Figur 1 zeigt in perspektivischer Darstellung eine Lötvorrichtung, die für das Auflöten von Mikropacks auf mehrlagige Leiterplatten eingesetzt wird und insgesamt vier Bügelelektroden B besitzt, deren Lötstege Ls zusammen die Form eines geschlossenen Rechtecks bilden. Der Elektrodenhalter H der Lötvorrichtung umfaßt vier kleine Säulen S, die durch Zwischenlagen Zl elektrisch voneinander isoliert sind. Dabei ist jede der U-förmig ausgebildeten Bügelelektroden B jeweils mit einem Schenkel an einer Säule S und mit dem anderen Schenkel an der benachbarten Säule S mittels Schrauben Sc auswechselbar befestigt. Zur Stromversorgung der vier Bügelelektroden B werden zwei auf einer Diagonale liegende Säulen S über einen ersten Zapfen Zpl mit dem einen Pol einer in Figur 1 nicht näher dargestellten Stromquelle verbunden, während die beiden anderen Säulen S über einen zweiten Zapfen Zp2 mit dem anderen Pol der Stromquelle verbunden werden. Die beiden im Querschnitt rechteckig ausgebildeten und durch eine Zwischenlage Zl elektrisch voneinander isolierten Zapfen Zp1 und Zp2 dienen dabei gleichzeitig als Einspannteil der gesamten Lötvorrichtung, die in einem in drei zueinander senkrechten Richtungen verfahren Kopf aufgenommen wird.

Damit nun der den Bügelelektroden B in Form von Stromimpulsen zugeführte Strom beim Aufsetzen auf die Anschlüsse eines Mikropacks nicht über niederohmige Leiterbahnen abfließen kann, sind in die Unterseiten der Lotstege Ls Nuten N eingebracht, in welchen jeweils ein streifenförmiger Einsatz E aus einem keramischen Werkstoff befestigt ist. Diese streifenförmigen Einsätze E können dabei in die Nuten N eingesintert werden oder gemäß der in Figur 2 gezeigten Darstellung mit Hilfe eines Wärmeleitklebers W in die jeweilige Nut N eingeklebt werden.

Bei dem vorstehend beschriebenen Ausführungsbeispiel wurden Bügelelektroden B verwendet, die beispielsweise aus einer Nickellegierung mit Zuschlägen von Molybdän, Chrom, Mangan, Kupfer, Silizium und Eisen besteht (Hastelloy C4 der Firma Dtsch. Langley Alloys GmbH, 6000 Frankfurt, DE). Die streifenförmigen Einsätze E bestehen beispielsweise aus Aluminiumoxid. Zum Einkleben der streifenförmigen Einsätze E in die Nuten N der Bügelelektroden B wurde ein Wärmeleitkleber W verwendet, der unter der Bezeichnung Epothek 71 im Handel erhältlich ist.


**Patentansprüche**

1. Lötvorrichtung mit mindestens einer durch elektrische Widerstandswärme erhitzbaren Bügelelektrode (B), insbesondere für das Auflöten hochpoliger elektronischer Bauelemente auf Leiterplatten,
**dadurch gekennzeichnet,**
daß in die Unterseite des Lötsteges (Ls) der Bügelelektrode (B) eine Nut (N) eingebracht ist und daß in der Nut (N) ein streifenförmiger Einsatz (E) aus einem elektrisch nichtleitenden, gut wärmeleitenden Werkstoff befestigt ist.

2. Lötvorrichtung nach Anspruch 1,
**dadurch gekennzeichnet,**
daß der streifenförmige Einsatz (E) aus einem keramischen Werkstoff besteht.

3. Lötvorrichtung nach Anspruch 2,
**dadurch gekennzeichnet,**
daß der streifenförmige Einsatz (E) aus Aluminiumoxid besteht.

4. Lötvorrichtung nach Anspruch 2,
**dadurch gekennzeichnet,**

daß der streifenförmige Einsatz (E) aus Berylliumoxid besteht.

5. Lötvorrichtung nach Anspruch 2,

**dadurch gekennzeichnet,**

daß der streifenförmige Einsatz (E) aus Aluminiumnitrid besteht.

6. Lötvorrichtung nach einem der vorhergehenden Ansprüche,

**dadurch gekennzeichnet,**

daß der streifenförmige Einsatz (E) in die Nut (N) eingesintert ist.

7. Lötvorrichtung nach einem der Ansprüche 1 bis 5,

**dadurch gekennzeichnet,**

daß der streifenförmige Einsatz (E) in die Nut (N) eingeklebt ist.

8. Lötvorrichtung nach Anspruch 7,

**dadurch gekennzeichnet,**

daß der streifenförmige Einsatz (E) mittels eines Wärmeleitklebers (W) in die Nut (N) eingeklebt ist.

## Claims

1. Soldering device with at least one stirrup electrode (B) which can be heated by electrical resistance heat, especially for soldering electronic components with a high number of pins onto circuit boards, characterised in that a groove (N) is inserted into the underside of the soldering web (LS) of the stirrup electrode (B) and in that a strip-shaped insert (E) of an electrically non-conductive material with good thermal conductivity is mounted in the groove (N).

2. Soldering device according to Claim 1, characterised in that the strip-shaped insert (E) consists of a ceramic material.

3. Soldering device according to Claim 2, characterised in that the strip-shaped insert (E) consista of aluminium oxide.

4. Soldering device according to Claim 2, characterised in that the strip-shaped insert (E) consists of beryllium oxide.

5. Soldering device according to Claim 2, characterised in that the strip-shaped insert (E) consiste of aluminium nitride.

6. Soldering device according to one of the preceding claims, characterised in that the strip-shaped insert (E) is sintered into the groove (N).

7. Soldering device according to one of Claims 1 to 5, characterised in that the strip-shaped insert (E) is bonded into the groove (N).

8. Soldering device according to Claim 7, characterised in that the strip-shaped insert (E) is bonded into the groove (N) by means of a heat-conducting adhesive (W).

## Revendications

1. Dispositif de brasage comportant au moins une électrode en forme d'étrier (B) pouvant être chauffée par la chaleur dégagée par une résistance électrique, notamment pour la fixation par brasage de composants électroniques possédant un grand nombre de bornes sur des plaquettes à circuits imprimés, caractérisé par le fait qu'une rainure (N) est ménagée dans la face inférieure de la barrette de brasage (Ls) de l'électrode en forme d'étrier (B) et qu'un insert en forme de bande (E) réalisé en un matériau non électriquement conducteur, mais qui réalise une bonne conduction thermique, est fixé dans la rainure (N).

2. Dispositif de brasage suivant la revendication 1, caractérisé par le fait que l'insert en forme de bande (E) est réalisé en un matériau céramique.

3. Dispositif de brasage suivant la revendication 2, caractérisé par le fait que l'insert en forme de bande (E) est réalisé en oxyde d'aluminium.

4. Dispositif de brasage suivant la revendication 2, caractérisé par le fait que l'insert en forme de bande (E) est formé d'oxyde de béryllium.

5. Dispositif de brasage suivant la revendication 2, caractérisé par le fait que l'insert en forme de bande (E) est formé de nitrure d'aluminium.

6. Dispositif de brasage suivant l'une des revendications précédentes, caractérisé par le fait que l'insert en forme de bande (E) est fixé par frittage dans la rainure (N).

7. Dispositif de brasage suivant l'une des revendications 1 à 5, caractérisé par le fait que l'insert en forme de bande (E) est collé dans la rainure (N).

8. Dispositif de brasage suivant la revendication 7, caractérisé par le fait que l'insert en forme de bande (E) est fixé par collage dans la rainure (N) à l'aide d'une colle fusible (W).

## FIG 1

## FIG 2